Europäisches Patentamt

European Patent Office

Office européen des brevets

(19)

(11) Veröffentlichungsnummer: **0 036 634**
**B1**

# EUROPÄISCHE PATENTSCHRIFT

(12)

(45) Veröffentlichungstag der Patentschrift:
08.08.84

(21) Anmeldenummer: 81102045.2

(22) Anmeldetag: 19.03.81

(51) Int. Cl.³: **H 01 L 21/31,** H 01 L 29/10, H 01 L 29/72

(54) Verfahren zur Herstellung einer bipolaren Transistorstruktur.

(30) Priorität: 24.03.80 US 133156

(43) Veröffentlichungstag der Anmeldung:
30.09.81 Patentblatt 81/39

(45) Bekanntmachung des Hinweises auf die Patenterteilung:
08.08.84 Patentblatt 84/32

(84) Benannte Vertragsstaaten:
DE FR GB

(56) Entgegenhaltungen:
EP - A - 0 005 721
DE - A - 2 818 090

IBM TECHNICAL DISCLOSURE BULLETIN, Band 22, Nr. 8A, Januar 1980 New York R.D. ISAAC et al. "Method for fabricating a self-aligned vertical pnp Transistor"

(73) Patentinhaber: International Business Machines Corporation, Old Orchard Road, Armonk, N.Y. 10504 (US)

(72) Erfinder: Jambotkar, Chakrapani Gajanan, 154 Hosner Mountain Road, Hopewell Jct., N.Y. (US)

(74) Vertreter: Gaugel, Heinz, Dipl.-Ing., Schönaicher Strasse 220, D-7030 Böblingen (DE)

## Beschreibung

Die Erfindung betrifft ein Verfahren zum Herstellen einer bipolaren Transistorstruktur gemäß dem ersten Teil des Anspruchs 1.

Zur Verbesserung der Eigenschaften bipolarer Transistorstrukturen ist man bemüht, die Herstellungsverfahren dahingehend zu verbessern, daß sich kleinere Strukturen erreichen lassen, die so dicht als möglich angeordnet werden können. Durch eine derart erhöhte Packungsdichte erzielt man erhöhte Schaltgeschwindigkeiten und eine größere Ausbeute bei der Herstellung der integrierten Anordnungen.

Eine Verbesserung der Schaltgeschwindigkeit bei bipolaren Transistorstrukturen erzielt man zumindest teilweise durch eine Verminderung des Basiswiderstandes, der Basis-Kollektor-Sperrschichtkapazität und der Kollektor-Substratkapazität. Bemühungen, diese Parameter durch eine Reduzierung der Größe der Strukturen zu erzielen, haben eine Reihe von Problemen aufgeworfen. Die konventionellen photolithographischen Techniken erfordern Zugeständnisse hinsichtlich der Toleranzen bei der gegenseitigen Ausrichtung der Masken und bei der Durchführung der Ätzprozesse. Außerdem erfordern die konventionellen Herstellungsverfahren eine Vielzahl komplexer Prozeßschritte, die jeweils ein Ausrichtverfahren notwendig machen. Die Vielzahl dieser Prozeßschritte erhöht die Wahrscheinlichkeit des Auftretens von Defekten und Fehlern. Man ist also gezwungen, die von Toleranzbedingungen bestimmten Regeln bei der Auslegung der integrierten Halbleiteranordnungen auf die Herstellungsprozesse zu übertragen. Diese Bedingungen laufen den Bemühungen zur Verminderung der Größe der Strukturen entgegen.

Ein bekanntes Verfahren zur Verminderung der Größe und Verbesserung der Ausbeute ist die Technik der automatischen Ausrichtung. Wird diese Technik nicht angewandt, läßt man also beispielsweise eine Fehlausrichtung zwischen Emitterzone und Basiskontakt zu, so ergeben sich Veränderungen im Widerstand der extrinsischen Basiszone. Außerdem kann die auftretende Fehlausrichtung an einer Kante der Emitterzone eine höhere Basis-Emitterspannung $V_{BE}$ bewirken als an der anderen. Das bedeutet aber, daß die automatische Ausrichtung der einzelnen Halbleiterzonen und Kontakte aufeinander nicht nur eine Reduzierung in der Strukturgröße zuläßt, sondern auch die Eigenschaften, wie Zuverlässigkeit und die Ausbeute erhöht.

Die Technik der automatischen Ausrichtung ist beispielsweise im »IBM Technical Disclosure Bulletin«, Vol. 21, Mai 1979, Nr. 12, Seite 4843 beschrieben. Dabei werden Basiskontakte aus polykristallinem Silicium dazu benutzt, um eine Selbstausrichtung eines Emitterkontaktes aus polykristallinem Silicium zu erreichen. Der Emitterkontakt wird als Störstellenquelle zur Bildung der Emitterzone herangezogen. Die Basis- und Emitterkontakte aus polykristallinem Silicium sind durch eine Oxidschicht voneinander getrennt.

Entsprechend ist in der US Patentschrift 4 157 269 die Selbstausrichtung von Basiskontakten und Emitterkontakt aus polykristallinem Silicium angegeben, wobei ebenfalls zur Trennung der Kontakte eine Oxidschicht dient. Zur Bildung dieser Oxidschichten sind mehrere Maskierungen und Ätzprozesse anzuwenden, wobei während eines Naßätzprozesses das Unterätzen einer Schicht ausgenutzt werden muß.

Im »IBM Technical Disclosure Bulletin«, Vol. 19, Nr. 12, Mai 1977 sind auf Seite 4601 unter dem Titel »Method for Reducing the Emitter-Base Contact Distance in Bipolar Transistors« zwei Prozesse beschrieben, bei denen der Abstand zwischen Emitter- und Basiskontakt reduziert wird, in dem horizontale Isolationsschichten zur Trennung verwendet werden und entweder der Basis- oder der Emitterkontakt aus polykristallinem Silicium hergestellt wird. Da jedoch zur Bildung der Isolationsschicht zwischen Emitter- und Basiskontakt konventionelle Verfahren angewandt werden, ist das in bezug auf den Abstand der Kontakte erzielte Ergebnis nicht optimal.

Auch in der US Patentschrift 4 160 991 ist ein Verfahren angegeben, durch das der Abstand zwischen Emitter- und Basiskontakten aus polykristallinem Silicium reduziert werden soll. Die Verwendung von Basiskontakten aus polykristallinem Silicium, die in bezug auf den Emitterkontakt eines bipolaren Transistors automatisch ausgerichtet sind ist auch in »IEEE Transactions on Electron Devices«, Vol. ED-26, Nr. 4, April 1979 unter dem Titel »A New Polysilicon Process for Bipolar Device-PSA Technology« beschrieben. Mit diesen Verfahren sind jedoch ebenfalls keine optimal kleinen Abstände zwischen den Kontakten erreichbar.

Weiterhin ist in der US Patentschrift 3 904 450 ein Verfahren zur Herstellung einer I²L-Struktur beschrieben, bei dem ein Muster aus Isolationszonen benützt wird, um zumindest teilweise das Einbringen von Störstellen derart zu gewährleisten, daß die Anzahl der erforderlichen Maskierungsschritte reduziert wird. Dabei wird dotiertes polykristallines Silicium sowohl als Diffusionsquelle als auch als leitendes Verbindungsmaterial benutzt. Schließlich ist aus der US Patentschrift 4 103 415 eine integrierte Halbleiteranordnung bekannt, bei der eine dielektrische Oxidschicht zwischen einem Gate aus polykristallinem Silicium und dem Kontaktloch zur Source oder Drain eines Feldeffekttransistors mit isoliertem Gate angeordnet ist. Die dielektrische Oxidschicht erlaubt es, daß das Kontaktloch sehr dicht bei dem Gate liegen kann, ohne daß zwischen beiden elektrische Kurzschlüsse auftreten.

Ein Verfahren nach dem 1. Teil des Anspruchs 1, das im wesentlichen die bereits beschriebenen bekannten Verfahren vereint zur Anwendung bringt, ist aus »IBM Technical Disclosure Bulletin«, Vol. 22, Nr. 8A, Januar 1980, Seiten 3393—3396 bekannt. Die durch Anwendung dieses Verfahrens erreichbare Transistorstruktur weist insbesondere noch die Nachteile eines hohen Serien-Kollektorwiderstandes in Verbindung mit einer hohen Basis-Kollektor-Kapazität auf.

Ausgehend vom genannten Stand der Technik löst die Erfindung, wie sie in den Ansprüchen gekennzeichnet ist, die Aufgabe, ein Verfahren zum Herstellen einer bipolaren Transistorstruktur anzugeben, das in Verbindung mit einfach beherrschbaren Prozeßschritten bei höherer Ausbeute die Erzielung optimaler Packungsdichten und einen auf ein Minimum reduzierten Serien-Kollektorwiderstand der Transistorstruktur gewährleistet.

Zusammengefaßt kann die Erfindung darin gesehen werden, daß bei der Herstellung bipolarer Transistorstrukturen Basiskontakte aus polykristallinem Silicium verwendet werden, die in bezug auf ein zur Diffusion oder Ionenimplantation benutztes Maskenfenster automatisch ausgerichtet sind. Dieses Maskenfenster wird dazu benutzt, insgesamt drei Zonen in die darunterliegende Halbleiterschicht einzubringen. Dabei werden die Basiskontakte selbst als Störstellenquelle zur Bildung einer extrinsischen Basiszone benutzt. Außerdem wird das polykristalline Silicium auf seiner Oberfläche und an den Seitenflächen des von ihm begrenzten Maskenfensters mit einer Siliciumdioxidschicht beschichtet. Durch gerichtetes Ionenätzen wird die Siliciumdioxidschicht im Bereich des Maskenfensters von der Oberfläche der Halbleiterschicht entfernt, während die Seitenflächen weiterhin mit der Siliciumdioxidschicht bedeckt bleiben. Im Bereich dieses auf diese Weise gebildeten Maskenfensters werden beispielsweise durch Ionenimplantation eine auf einer darunterliegenden Subkollektorzone aufsitzende Erweiterungszone der Subkollektorzone, eine intrinsische Basiszone und eine flache Emitterzone in die Halbleiterschicht eingebracht. Die Isolationsschicht an den Seitenflächen des Maskenfensters definiert dabei nicht nur die Ausdehnung des Maskenfensters selbst, sondern sie bildet auch eine schmale, wiederum automatisch ausgerichtete Isolationsschicht zwischen dem Basiskontakt und dem im Bereich des Maskenfensters aufzubringenden Emitterkontakt.

Das erfindungsgemäße Verfahren liefert mit hoher Ausbeute Transistorstrukturen hoher Integrationsdichte, hoher Schaltgeschwindigkeit und guter Emitterstrom-Basisemitterspannungscharakteristik, niedrigem Basiswiderstand, reduzierter Kollektor-Substratkapazität und verminderter Kollektor-Basis-Kapazität bei auf ein Minimum reduziertem Serien-Kollektorwiderstand.

Im folgenden wird die Erfindung anhand der Zeichnung näher erläutert. Es zeigt

Fig. 1A die Draufsicht einer nach dem erfindungsgemäßen Verfahren hergestellten bipolaren Transistorstruktur,

Fig. 1B eine Schnittansicht entlang der Schnittlinie 1B-1B der Transistorstruktur nach Fig. 1A und

Fig. 2 bis 14 Schnittansichten einer nach dem erfindungsgemäßen Verfahren hergestellten Transistorstruktur in aufeinanderfolgenden Stufen des Herstellungsverfahrens.

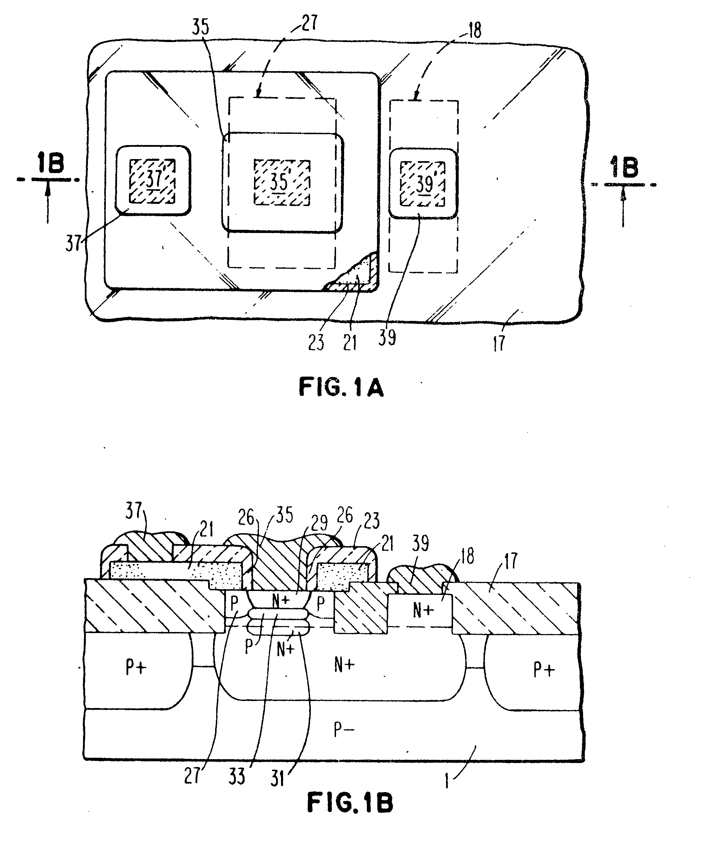

Ausgangsmaterial für die nach dem erfindungsgemäßen Verfahren hergestellte, in den Fig. 1A und 1B gezeigte Transistorstruktur ist ein $P^-$-dotiertes Halbleitersubstrat 1 aus Silicium. Ein Metallkontakt 35 stellt die Ohmsche Verbindung zu einer Emitterzone 29 her, was der Fig. 1B zu entnehmen ist, wobei die direkte Metall-Siliciumverbindung durch das Gebiet 35' in Fig. 1A angegeben ist. Ein Metallkontakt 37 liefert die Ohmsche Verbindung zur polykristallinen Siliciumschicht 21 im Kontaktbereich 37', wie es in Fig. 1 dargestellt ist. Die polykristalline Siliciumschicht kontaktiert, wie es in Fig. 1B dargestellt ist die extrinsische Basiszone 27. In entsprechender Weise bildet die Metallschicht 39 den Ohmschen Kontakt zu einer Kollektorkontaktierungszone 18 in einem Kontaktbereich 39'. Wie es der Fig. 1A zu entnehmen ist, umgibt eine abgesenkte Oxidzone 17 die Struktur. Außerdem trennen Oxidschichten 23 und 26 die polykristalline Siliciumschicht vom Metallkontakt 35.

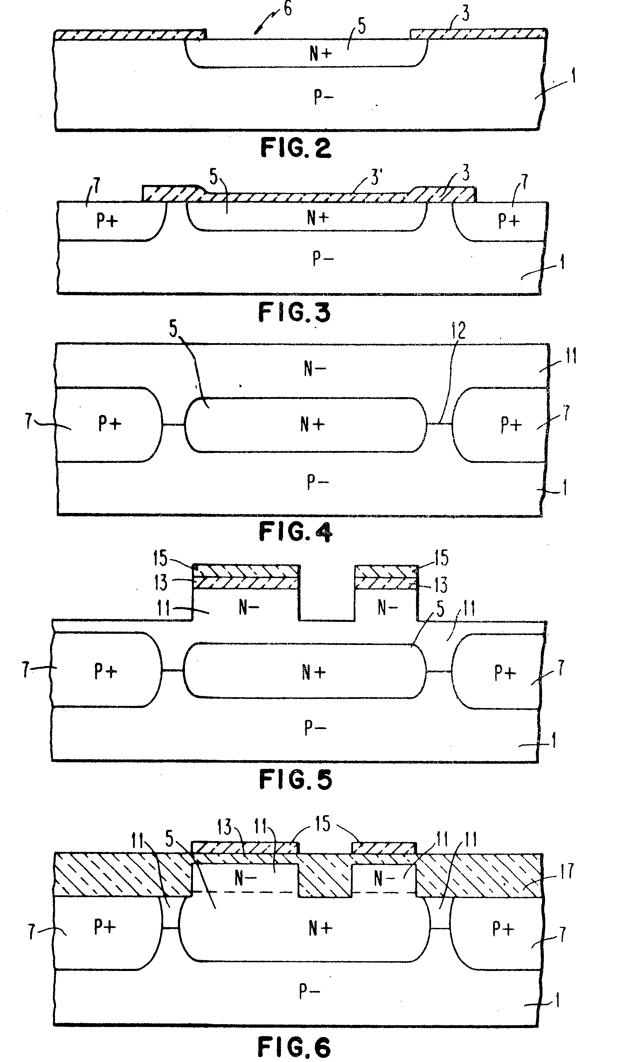

Das eigentliche Herstellungsverfahren der Transistorstruktur wird im folgenden anhand der Fig. 2 bis 14 beschrieben. Dabei wird im betrachteten Ausführungsbeispiel ein NPN-Transistor hergestellt. Selbstverständlich könnten die Leitungstypen der Zonen auch umgekehrt gewählt werden, so daß in entsprechender Weise ein PNP-Transistor entstünde. Im betrachteten Ausführungsbeispiel wird von dem $P^-$-dotierten Halbleitersubstrat 1 aus Silicium ausgegangen, wie es in Fig. 2 dargestellt ist. In dieses Halbleitersubstrat 1 wird in einem konventionellen Diffusionsprozeß eine Halbleiterzone 5 eingebracht. Selbstverständlich kann die Zone 5 auch auf andere Weise, z. B. durch Ionenimplantation eingebracht werden. Bei der Herstellung der Zone 5 durch Diffusion wird auf die Oberfläche des Substrats zunächst eine Isolationsschicht 3 aufgebracht, die, wenn das Substrat aus Silicium besteht, durch thermische Oxidation der Oberfläche zu Siliciumdioxid gebildet wird. Die Dicke dieser Siliciumdioxidschicht beträgt beispielsweise 350 nm.

In konventioneller Photoätztechnik wird in der Oxidschicht 3 ein Fenster 6 geöffnet. Im Bereich dieses Fensters wird die Zone 5 eingebracht, wobei die verbliebenen Teile der Oxidschicht 3 als Maske dienen. Dazu wird das Substrat 1 in einen Diffusionsofen gebracht, in dem beispielsweise Arsen als Dotierungsstoff in das Substrat eindiffundiert wird.

Dabei entsteht die $N^+$-dotierte Zone 5, die beim fertigen Transistor als Subkollektorzone dient. Die $N^+$-dotierte Zone 5 kann dadurch weiter in das Substrat 1 eingetrieben werden, daß das Substrat einem zusätzlichen Erwärmungsprozeß ausgesetzt wird.

Anschließend wird im Bereich des Maskenfensters 6 eine thermische Siliciumdioxidschicht 3' in einer Dicke von etwa 350 nm aufgebracht. Bei diesem Prozeß wird die bereits vorhandene Siliciumdioxidschicht 3 ebenfalls verstärkt. Dieser Vorgang ist der Fig. 3 zu entnehmen. Nunmehr werden Teile der Siliciumdioxidschicht selektiv entfernt, was wiederum durch konventionelle Photoätztechnik geschehen kann. In einem weiteren Diffusionsprozeß werden P+-Zonen 7 in das Halbleitersubstrat 1 eindiffundiert. Die auf diese Weise gebildete Struktur ist in Fig. 3 dargestellt. Anschließend wird die Siliciumdioxidschicht 3, 3' entfernt.

In nächsten Verfahrensschritt wird auf das Halbleitersubstrat 1 eine Epitaxieschicht 11 aufgebracht. Die Dicke dieser Epitaxieschicht ist frei wählbar, im Hinblick auf die zu bildenden Transistoren optimaler Eigenschaften wird man eine Dicke von weniger als etwa 2 µm anstreben. Typischerweise beträgt die Dicke der Epitaxieschicht 11 etwa 1,2 µm. Das Aufbringen der Epitaxieschicht 11 erfolgt in konventioneller Weise, wobei bei Temperaturen von 1000 bis 2000°C $SiCl_4/H_2$ oder $SiH_4/H_2$ Mischungen verwendet werden. Wie der Fig. 4 zu entnehmen ist, diffundieren die Störstellen der Zonen 5 und 7 während des Epitaxieprozesses nach oben in die Epitaxieschicht aus. Die Linie 12 bezeichnet in Fig. 4 die ursprüngliche Oberfläche des Substrats 1, an der der Ausgangspunkt der Epitaxie liegt.

Im nächsten Prozeßschritt wird auf die Epitaxieschicht 11 eine Siliciumdioxidschicht aufgebracht. Teile 13 dieser Schicht sind in der Struktur gemäß Fig. 5 noch vorhanden. Auf die Siliciumdioxidschicht 13 wird eine Siliciumnitridschicht 15 aufgebracht. Anschließend werden auf photolithographischem Wege die Teile dieser beiden Schichten entfernt, so daß die in Fig. 5 dargestellte Struktur entsteht. Im Bereich der auf diese Weise gebildeten Fenster in den beiden Schichten 13 und 15 werden nunmehr Gräben in die N⁻-dotierte Epitaxieschicht 11 geätzt, die über den P+-dotierten Zonen 7 und den N+-dotierten Zonen 5 angeordnet sind.

Im anschließenden Prozeßschritt werden die Gräben in der Epitaxieschicht 11 durch thermische Oxidation mit einer Siliciumdioxidschicht 17 soweit aufgefüllt, daß in Verbindung mit der Siliciumdioxidschicht 13 eine planare Oberfläche entsteht. Die entsprechende Struktur ist in Fig. 6 dargestellt. Während des thermischen Aufwachsens der Siliciumdioxidschicht 17 diffundieren die Störstellen der Zonen 7 und 5 weiter nach oben in die Epitaxieschicht aus.

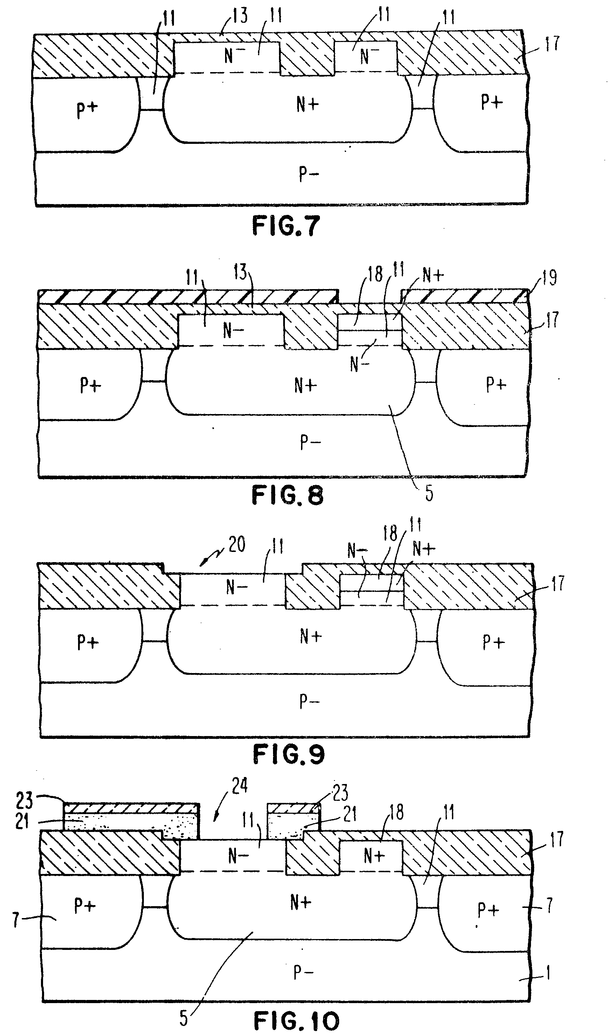

Nunmehr wird die Siliciumnitridschicht 15 entfernt, wie es der Fig. 7 zu entnehmen ist.

Nach dem geschilderten, auf der Siliciumdioxidschicht 17 gebildeten abgesenkten Oxidbereiche wird eine Kollektorverbindungszone 18 (Fig. 8) erzeugt. Dies kann auf konventionelle Weise geschehen. Dazu wird eine Photolackschicht 19 auf die Siliciumdioxidschicht 17 aufgebracht, belichtet und entwickelt, um ein den Bereich der zu bildenden Kollektorverbindungszone 18 definierendes Fenster freizulegen. Im Bereich dieses Fensters werden N+-Störstellen, beispielsweise Phosphor, durch Ionenimplantation eingebracht. Dabei entsteht die N+-dotierte Kollektorverbindungszone 18. Anschließend wird die Photolackschicht 19 entfernt.

Im nächsten Verfahrensschritt wird der Teil 13 der Siliciumdioxidschicht über der N⁻-Epitaxieschicht 11 vorzugsweise etwas überlappend entfernt, wobei ein Fenster 20 freigelegt wird.

Die entsprechende Struktur ist in Fig. 9 dargestellt. Das Freilegen des Fensters 20 geschieht wiederum auf konventionellem photolithographischem Wege.

Nunmehr wird eine P-dotierte polykristalline Siliciumschicht 21 aufgebracht, wie es der Fig. 10 zu entnehmen ist. Die Dicke dieser Schicht kann etwa 800 nm betragen. Die Dotierung des polykristallinen Siliciums kann entweder während des Aufbringens der Schicht oder unter Anwendung von Ionenimplantation nach dem Aufbringen der Schicht erfolgen. Auf die polykristalline Siliciumschicht 21 wird eine pyrolytische Siliciumdioxidschicht 23 aufgebracht. Die Dicke dieser Schicht liegt typischerweise im Bereich von 500 bis 600 nm.

Wie in Fig. 10 gezeigt, werden Teile der Siliciumdioxidschicht 23 auf photolithographischem Wege selektiv entfernt. Vorzugsweise werden diese Teile durch reaktives Ionenätzen entfernt. Im nächsten Prozeßschritt wird der auf diese Weise freigelegte Teil der polykristallinen Siliciumschicht bis zur Oberfläche der Epitaxieschicht 11 abgeätzt. Auf diese Weise entsteht ein Fenster 24. Das Ätzen der polykristallinen Siliciumschicht erfolgt wiederum vorzugsweise durch reaktives Ionenätzen. Bei diesem Ätzvorgang wird angestrebt, ihn so zu beendigen, daß eine minimale Ätzung der unter der polykristallinen Siliciumschicht 21 liegenden Epitaxieschicht 11 erfolgt. Es ist jedoch darauf hinzuweisen, daß eine extrem genaue Kontrolle des Endzeitpunktes des Ätzprozesses nicht erforderlich ist, da es keine Folgen hat, wenn entweder einige hundert Angström der Epitaxieschicht abgeht oder einige hundert Angström der polykristallinen Siliciumschicht auf der Epitaxieschicht zurückbleiben.

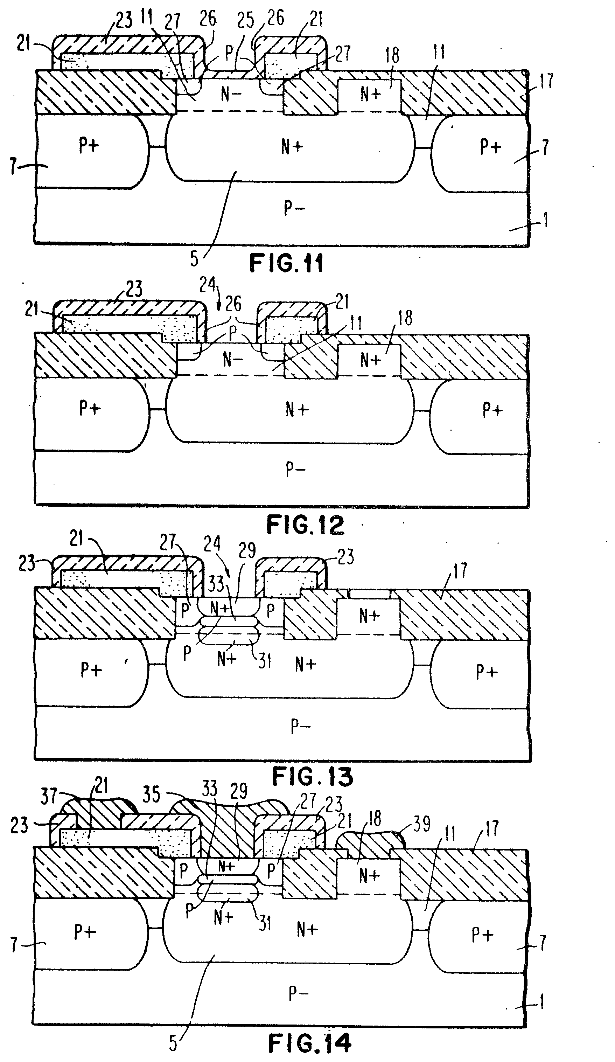

Nach dem Freilegen des Fensters 24 wird durch thermische Oxidation im Bereich des Fensters auf die Epitaxieschicht 11 und auf die senkrechten Wandflächen des Fensters im Bereich der polykristallinen Siliciumschicht 21 eine Siliciumdioxidschicht 25 und 26 thermisch aufgebracht, wie es in Fig. 11 dargestellt ist. Die Dicke dieser Schicht beträgt typischerweise 0,2 bis 0,2 µm. Bei der thermischen Oxidation wird auch die Siliciumdioxidschicht 23 leicht verstärkt. Während des thermischen Oxidationsprozesses diffundieren Störstellen aus der P-dotierten polykristallinen Siliciumschicht 21 in die darunterliegenden Gebiete der N⁻-dotierten Epitaxieschicht 11. Auf diese Weise entstehen, wie in Fig. 11 dargestellt, in der Epitaxieschicht 11 die P-dotierten Gebiete 27, die später die extrinsische Basiszone bilden. Das bedeutet also, daß gleichzeitig mit der Bildung der Siliciumdioxidschicht 26 an den Seitenflächen des Fensters 24 auch die extrinsische Basiszone 27 entsteht.

Im nächsten Prozeßschritt wird die Siliciumdioxidschicht 25 in dem von der seitlichen Siliciumdioxidschicht 26 bestimmten Bereich von der Oberfläche der Epitaxieschicht 11 entfernt. Dies geschieht durch gerichtetes, reaktives lonenätzen. Dabei wird ein lonenstrahl senkrecht zur Oberfläche der Siliciumdioxidschicht 25, also parallel zur Oberfläche der Siliciumdioxidschicht 26 auf die Struktur gerichtet. Bei diesem Ätzprozeß wird also nur die Siliciumdioxidschicht 25 am Grunde des Maskenfensters 24 entfernt, während die Siliciumdioxidschicht 26 an den Seitenflächen des Maskenfensters erhalten bleibt. Dies ist in Fig. 12 dargestellt. Bei diesem Ätzprozeß wird auch ein Teil der Siliciumdioxidschicht 23 abgeätzt. Da diese Schicht im Vergleich zu der Siliciumdioxidschicht 25 jedoch ausreichend dick gewählt ist, verbleibt eine Restschicht, deren Dicke ausreichend ist, um als Dielektrikum zu wirken.

Nach der Entfernung der Siliciumdioxidschicht 25 ist die Struktur, wie sie in Fig. 12 dargestellt ist, so vorbereitet, daß die Emitterzone, die intrinsische Basiszone und eine auf der darunterliegenden Subkollektorzone aufsitzende Erweiterungszone der Subkollektorzone durch das Maskenfenster 24 hindurch hergestellt werden können. Dabei sind diese Zonen automatisch auf die durch die verbleibende polykristalline Siliciumschicht 21 gebildeten Basiskontakte und die seitliche Siliciumdioxidschicht 26 ausgerichtet. Die Emitterzone und die intrinsische Basiszone lassen sich durch Diffusion aber auch vorzugsweise durch lonenimplantation herstellen. Die Dicke dieser Emitterzone kann etwa 0,2 µm betragen. Durch geeignete Wahl der Implantationsenergie und der anzuwendenden Wärmezyklen läßt sich die Emitterdicke festlegen. In entsprechender Weise kann die in Fig. 13 angegebene, auf der Subkollektorzone 5 aufsitzende Erweiterungszone 31 der Subkollektorzone 5 durch Implantation von Phosphor gebildet werden. Die Dicke der genannten Erweiterungszone 31 der Subkollektorzone 5 wird typischerweise etwa 0,2 µm betragen. Die Parameter sind so zu wählen, daß die Erweiterungszone 31 auf der Subkollektorzone 5 aufsitzt bzw. in diese eintaucht. Die Aufgabe der Erweiterungszone 31 besteht darin, den Serien-Kollektorwiderstand im intrinsischen Transistorbereich direkt unterhalb der Emitterzone auf ein Minimum zu reduzieren während gleichzeitig die Kollektor-Basiskapazität im Bereich der extrinsischen Basiszone ebenfalls auf ein Minimum reduziert wird. Die Kollektorverbindungszone 18 in der Struktur gemäß Fig. 8 wurde durch lonenimplantation hergestellt. Durch die nachfolgenden Erwärmungsprozesse ist diese Zone 18 ausdiffundiert und hat sich mit der Subkollektorzone 5 vereinigt. Um den Serienwiderstand der Kollektorverbindungszone 18 weiter herabzusetzen kann in deren Bereich gleichzeitig mit der Emitterzone und der Erweiterungszone 31 zusätzlich eine N⁺-dotierte Zone eindiffundiert werden. Neben der Emitterzone 29 und der Erweiterungszone 31 der Subkollektorzone 5 kann auch die intrinsische Basiszone durch lonenimplantation durch das Maskenfenster 24 hergestellt werden. Dazu wird Bor mit mittlerer Energie und relativ niedriger Dosis implantiert. Durch Wahl der Prozeßparameter läßt sich die gewünschte Tiefe der intrinsischen Basiszone 33 einstellen.

Es ist festzustellen, daß bei der Implantation der Erweiterungszone der Subkollektorzone, der intrinsischen Basiszone und der Emitterzone keinerlei Maskierung erforderlich ist. Die Dicke der Siliciumdioxidschicht 23 auf der polykristallinen Siliciumschicht 21 ist so gewählt, daß bei der Implantation keine lonen in die polykristalline Siliciumschicht gelangen können. Die Implantation von lonen erfolgt exakt in dem gewünschten intrinsischen, aktiven Transistorbereich. Es ist auch darauf hinzuweisen, daß durch das Vorsehen der N⁺-dotierten Erweiterungszone 31 der Subkollektorzone 5 die Toleranz der Ätztiefe beim Ätzen der polykristallinen Siliciumschicht 21 zur Bildung des Fensters 24 völlig unkritisch wird. Das heißt der Einfluß der Ätztoleranzen auf die Parameter des Transistors wird auf ein Minimum reduziert. Hinzuweisen ist auch auf die Tatsache, daß die nach den Implantationen durch das Fenster 24 anzuwendenden Temperaturzyklen eine weitere Eindiffusion der extrinsischen Basiszone 27 in die Epitaxieschicht 11 bewirken. Diese zusätzliche Diffusion kann bereits ausreichend sein, eine gute Kopplung zwischen intrinsischer Basiszone 33 und extrinsischer Basiszone 27 herzustellen.

Nach Durchführung der beschriebenen lonenimplantationen im Bereich des Fensters 24 wird die Struktur einem Temperaturzyklus ausgesetzt. Anschließend werden mit Hilfe der Photoätztechnik Fenster in die die polykristalline Siliciumschicht 21 bedeckende Siliciumdioxidschicht 23 eingepaßt. Über diese Fenster erfolgt dann die Kontaktierung der die Basiskontakte bildenden polykristallinen Siliciumschicht 21.

Wie der Fig. 14 zu entnehmen ist, werden die Ohmschen Anschlüsse zur Emitterzone, zum Basiskontakt und zur Kollektorverbindungszone über Metallkontakte 35, 37 und 39 hergestellt. Die Herstellung dieser Kontakte erfolgt in konventioneller Photoätz- und Metallisierungstechnik. Um insbesondere an den Rändern der Emitterzone durchgehende Metallschichten zu gewährleisten, ohne Metallschichten extremer Dicke verwenden zu müssen, kann die auf der polykristallinen Siliciumschicht 21 angeordnete Siliciumdioxidschicht 23 vor Aufbringen der Metallisierung durch reaktives lonenätzen etwas in ihrer Dicke verringert werden. Bei dieser Ätzung gilt es darauf zu achten, daß freigelegtes Silicium nicht beeinträchtigt wird. Wesentlich ist, daß die Seitenflächen der polykristallinen Siliciumschicht 21 bedeckende Siliciumdioxidschicht 26 unbeeinträchtigt bleibt und dadurch als automatisch ausgerichtete Isolation zwischen Emitter- und Basiskontakt dienen kann, die nur einen minimalen Platzaufwand erforderlich macht.

**Patentansprüche**

1. Verfahren zum Herstellen einer bipolaren Transistorstruktur, bei dem

(a) auf eine Halbleiterschicht (11) eines ersten Leitungstyps eine hochdotierte, polykristalline Siliciumschicht (21) des entgegengesetzten zweiten Leitungstyps aufgebracht wird,

(b) in der polykristallinen Siliciumschicht (21) ein einen intrinsischen Basiszonenbereich definierendes Fenster (24) geöffnet wird,

(c) im Bereich des Fensters (24) auf die Halbleiterschicht (11) und an den Seitenflächen des Fensters eine dünne Isolationsschicht (25, 26) aufgebracht wird,

(d) aus der polykristallinen Siliciumschicht (21) die extrinsische Basiszone (27) in die Halbleiterschicht (11) eindiffundiert wird,

(e) die Isolationsschicht (25) von der Oberfläche der Halbleiterschicht (11) entfernt wird, wobei die Isolationsschicht (26) an den Seitenflächen des Fensters (24) erhalten bleibt,

(f) durch das durch die verbliebene Isolationsschicht (26) begrenzte Fenster (24) sowohl die intrinsische Basiszone (33) als auch in diese die Emitterzone (29) in die Halbleiterschicht (11) eingebracht wird und

(g) die polykristalline Siliciumschicht (21) als Basiskontakt verwendet und an der Emitterzone ein in bezug auf den Basiskontakt selbstausgerichteter Emitterkontakt (35) angeordnet wird,

dadurch gekennzeichnet, daß
die Halbleiterschicht (11) aus einer auf ein Halbleitersubstrat (1) aufgebrachten Epitaxieschicht gebildet wird, wobei im Bereich der Grenzfläche zwischen Halbleitersubstrat (1) und Halbleiterschicht (11) eine Subkollektorzone (5) des ersten Leitungstyps eingebracht wird, und daß im Schritt (f) ebenfalls durch das Fenster (24) im Bereich unterhalb der intrinsischen Basiszone (33) eine den ersten Leitungstyp aufweisende Erweiterungszone (31) der Subkollektorzone (5) in die Halbleiterschicht (11) eingebracht wird.

2. Verfahren nach Anspruch 1, dadurch gekennzeichnet, daß im Schritt (e) die Entfernung der Isolationsschicht (25) durch gerichtetes, reaktives Ionenätzen erfolgt.

3. Verfahren nach Anspruch 1 oder 2, dadurch gekennzeichnet, daß die Erweiterungszone (31) durch Ionenimplantation von Phosphor bei relativ hoher Implantationsenergie und hoher Dosis gebildet wird.

4. Verfahren nach einem der Ansprüche 1 bis 3, dadurch gekennzeichnet, daß die Emitterzone (29) durch Ionenimplantation von Arsen bei niedriger Implantationsenergie und hoher Dosis hergestellt wird.

5. Verfahren nach einem der Ansprüche 1 bis 4, dadurch gekennzeichnet, daß die intrinsische Basiszone (33) durch Ionenimplantation von Bor bei mittlerer Implantationsenergie und niedriger Dosis hergestellt wird.

6. Verfahren nach den Ansprüchen 1 bis 5, dadurch gekennzeichnet, daß die Isolationsschicht (25, 26) aus Siliciumdioxid besteht, das durch thermische Oxidation gebildet wird.

**Claims**

1. Method of making a bipolar transistor structure, where

a) onto a semiconductor layer (11) of a first conductivity type a highly doped, polycrystalline silicon layer (21) of the opposite second conductivity type is applied,

b) in the polycrystalline silicon layer (21) a window defining an intrinsic base region is opened,

c) in the area of the window (24) a thin insulating layer (25, 26) is applied on the sidewalls of the window,

d) from the polycrystalline silicon layer (21) the extrinsic base region (27) is diffused into the semiconductor layer (11),

e) the insulating layer (25) is removed from the surface of the semiconductor layer (11), with the insulating layer (26) on the sidewalls of the window (24) remaining,

f) through the window (24) limited by the remaining insulating layer (26) the intrinsic base region (33) is inserted, as well as into said regions the emitter region (29) is introduced into the semiconductor layer (11),

g) the polycrystalline layer (21) is used as a base contact, and at the emitter region an emitter contact (35) self-aligned with respect to the base contact is arranged,

characterized in that the semiconductor layer (11) is formed of an epitaxial layer applied on a semiconductor substrate (1), a subcollector region (5) of the first conductivity type being introduced in the area of the interface between semiconductor substrate (1) and semiconductor layer (11), and that in step f), equally through the window (24), in the area beneath the intrinsic base region (33) a first conductivity type raised region (31) of the subcollector region (5) is introduced in the semiconductor layer (11).

2. Method as claimed in claim 1, characterized in that in step e) the insulating layer (25) is removed through directional reactive ion etching.

3. Method as claimed in any one of claims 1 or 2, characterized in that the raised region (31) is formed by the ion implantation of phosphorus with a relatively high implantation energy and high dosage.

4. Method as claimed in any one of claims 1 to 3, characterized in that the emitter region (29) is made by the ion implantation of arsenic with a relatively low implantation energy and high dosage.

5. Method as claimed in any one of claims 1 to 4, characterized in that the intrinsic base region (33) is made by ion implantations of boron with a medium implantation energy and low dosage.

6. Method as claimed in any one of claims 1 to 5, characterized in that the insulating layer (25, 26) consists of silicon dioxide made by thermal oxidation.

## Revendications

1. Procédé pour fabriquer une structure de transistor bipolaire où,

(a) on dépose sur une couche semiconductrie (11) d'un premier type de conductivité une couche de silicium polycristallin fortement dopée (21) d'un second type de conductivité opposé au premier,

(b) on pratique dans ladite couche de silicium polycristallin (21) une fenêtre (24) définissant une zone de base intrinsèque,

(c) on dépose dans la région de ladite fenêtre sur ladite couche semiconductrice (11) et sur les surfaces latérales de ladite fenêtre une couche d'isolation mince (25, 26),

(d) on diffuse à partir de la couche de silicium polycristalline (21) dans ladite couche semiconductrice (11) une zone de base extrinsèque (27),

(e) on enlève ladite couche d'isolation (25) de la surface de ladite couche semiconductrice (11) tout en préservant ladite couche d'isolation (26) recouvrant lesdites surfaces latérales de ladite fenêtre (24),

(f) on insère dans ladite couche semiconductrice (11) à travers ladite fenêtre (24) délimitée par la couche d'isolation (26) qui reste la zone de base intrinsèque (33) et dans celle-ci la zone d'émetteur (29), et

(g) on utilise ladite couche de silicium polycristalline (21) comme contact de base et on dispose sur la zone d'émetteur un contact d'émetteur (35) auto-aligné par rapport au contact de base,

caractérisé en ce que ladite couche semiconductrice (11) est formée à partir d'une couche épitaxique déposée sur le substrat semiconducteur (1), une zone de sous-collecteur (5) dudit premier type de conductivité étant insérée dans la région de la surface de séparation entre d'une part ledit substrat semiconducteur (1) et d'autre part ladite couche semiconductrice (11), et qu'au cours de l'étape (f) on insère dans la couche semiconductrice (11) à travers la même fenêtre (24) dans la région sous-jacente à la zone de base intrinsèque (33) une zone additionelle (31) à la zone de sous-collecteur (5), présentant un premier type de conductivité.

2. Procédé selon la revendication 1, caractérisé en ce qu'au cours de l'étape (e) ladite couche d'isolation (25) est enlevée par décapage dirigé au moyen d'ions réactifs.

3. Procédé selon la revendication 1 ou 2, caractérisé en que ladite zone additionnelle (31) est obtenue par implantation d'ions de phosphore réalisée avec une énergie d'implantation relativement élevée et une dose d'ions élevée.

4. Procédé selon une des revendications 1 à 3, caractérisé en ce que ladite zone d'émetteur (29) est obtenue par implantation d'ions d'arsenic réalisée avec une énergie d'implantation faible et une dose d'ions élevée.

5. Procédé selon une des revendications 1 à 4, caractérisé en ce que ladite zone de base intrinsèque (33) est obtenue par implantation d'ions de bore réalisée avec une énergie d'implantation moyenne et une dose d'ions faible.

6. Procédé selon les revendications 1 à 5, caractérisé en ce que ladite couche d'isolation (25, 26) est en dioxyde de silicium obtenu par oxydation thermique.

FIG. 1A

FIG. 1B

**FIG.2**

**FIG.3**

**FIG.4**

**FIG.5**

**FIG.6**

FIG.7

FIG. 8

FIG.9

FIG.1O

FIG.11

FIG.12

FIG.13

FIG.14